(19) Europäisches Patentamt / European Patent Office / Office européen des brevets

(11) **EP 3 764 542 B1**

(12) **EUROPEAN PATENT SPECIFICATION**

(45) Date of publication and mention
of the grant of the patent:
**21.09.2022 Bulletin 2022/38**

(21) Application number: **19193785.3**

(22) Date of filing: **27.08.2019**

(51) International Patent Classification (IPC):
**H03H 21/00** $^{(2006.01)}$      **H03K 5/1252** $^{(2006.01)}$

(52) Cooperative Patent Classification (CPC):
**H03H 21/0012; H03K 5/1252**

(54) **SIGNAL ENHANCER AND METHOD FOR WEAK AND BLIND SIGNAL DENOISING AND EXTRACTING**

SIGNALVERSTÄRKER UND VERFAHREN ZUR ENTRAUSCHUNG UND EXTRAKTION VON SCHWACHEN UND BLINDEN SIGNALEN

REHAUSSEUR DE SIGNAL ET PROCÉDÉ DE DÉBRUITAGE ET D'EXTRACTION DE SIGNAUX FAIBLES ET AVEUGLES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.07.2019 CN 201910618437**

(43) Date of publication of application:
**13.01.2021 Bulletin 2021/02**

(73) Proprietors:
• **Harbin Institute of Technology, Shenzhen**
**Shenzhen, Guangdong 518000 (CN)**
• **Harbin Institute Of Technology**
**Harbin, Heilongjiang 150001 (CN)**

(72) Inventors:
• **SHEN, Yi**
**Shenzhen, Guangdong Province 518000 (CN)**
• **HAO, Qiushi**
**Shenzhen, Guangdong Province 518000 (CN)**
• **WANG, Yan**
**Shenzhen, Guangdong Province 518000 (CN)**
• **ZHANG, Xin**
**Shenzhen, Guangdong Province 518000 (CN)**
• **WANG, Kangwei**
**Shenzhen, Guangdong Province 518000 (CN)**
• **LOU, Yunjiang**
**Shenzhen, Guangdong Province 518000 (CN)**

(74) Representative: **Hoefer & Partner Patentanwälte mbB**
**Pilgersheimer Straße 20**
**81543 München (DE)**

(56) References cited:
**EP-A1- 3 182 413      US-A1- 2011 305 306**

• **Roshahliza M Ramli ET AL: "A Review of Adaptive Line Enhancers for Noise Cancellation", Australian Journal of Basic and Applied Sciences, 1 June 2012 (2012-06-01), pages 337-352, XP055408949, Retrieved from the Internet: URL:https://pdfs.semanticscholar.org/9bf8/af360ef0ffd7d5f764f0249eaefc7afe0ad8.pdf [retrieved on 2017-09-21]**
• **KANG JUN-SU ET AL: "Adaptive EEG noise filtering for coherence analysis", 2014 INTERNATIONAL WINTER WORKSHOP ON BRAIN-COMPUTER INTERFACE (BCI), IEEE, 17 February 2014 (2014-02-17), pages 1-4, XP032584145, DOI: 10.1109/IWW-BCI.2014.6782569 [retrieved on 2014-04-02]**

## Description

### FIELD

The invention relates to an improved signal enhancer, a signal denoising and extracting method thereon, as well as a signal detection system including the enhancer. In particular, the invention is applicable in denoising and extracting of the weak and blind signal with strong noise.

### BACKGROUND

High-speed railway, as a fast, efficient, comfortable, and green means of transportation, has become a trend of international passenger transport and been put into operation in China, UK, France, Japan, Germany, Italy, and many other countries. However, due to the rapid development of the high-speed railway, the increasing vehicle speed, transportation amount, and load have made the random cracks of wheel-rail rolling contact fatigue become the fatal threat to the safe operation of high-speed railway.

Existing detection techniques and methods are limited by the low detection speed, the unavoidable dead-zone, and the insensitivity to subliminal defects, which don't meet the detection demand of wheels and rails in high-speed railway. Acoustic Emission (AE) is a passive, dynamic, and non-destructive detection technology. It has the merits of sensitivity, real-time detection, and low requirement for the geometry of the object, and is suitable for wheel/rail health monitoring and defect detection. For example, in the reference by Lu Zhou et al., titled "Contemporary Inspection and Monitoring for High-Speed Rail System" (http://dx.doi.org/10.5772/intechopen.81159), applications of AE and other detection technologies on the detection of high-speed railway system are discussed.

Besides, according to recent researches, the amplitude of the wheel-rail rolling noise is far higher than that of the detected defect signal and has a strong positive relationship with the vehicle speed. Moreover, the spectrum of the noise is partially overlapped with the one of the defect signal, where simple filtering processing cannot achieve the purpose of defect detection. Therefore, the unavoidable noise during operation is the key problem impeding the application of AE technology in real-time detection of high-speed railway. Investigation of this problem has great significance to the denoising of the noise and the detection of the defect, which raises new demands for the denoising method. Specifically, when the amplitude of the noise is far higher than that of the target defect signal and there is an overlap between their spectrums, the method should be able to cancel the strong noise and extract the blind target signal. Here, the term "blind" refers to the target signal is unknown and without its prior information.

In a paper (see Roshahliza M Ramli et al: "A Review of Adaptive Line Enhancers for Noise Cancellation", Australian Journal of Basic and Applied Sciences, 1 June 2012 (2012-06-01), pages 337-352), a signal enhancer is disclosed including a delay module, an adaptive filter and a parameter adjustment module. The signal enhancer in this paper is problematic in that it cannot compensate irregularities of the signal that are output by the adaptive filter while removing noises.

European patent application EP 3 182 413 A1 discloses an adaptive line enhancer (ALE) based method using an ALE with a frequency-dependent step-size. The proposed frequency-domain adaptive line enhancer (FDALE) is employed as a single-channel noise reduction system for removing harmonic noise from noisy speech. This patent application is silent in compensating irregularities of the signal that are output by the adaptive filter while removing noises.

In another paper (see Kang Jun-Su et al:"Adaptive EEG noise filtering for coherence analysis", 2014 INTERNATIONAL WINTER WORKSHOP ON BRAIN COMPUTER INTERFACE (BCI), IEEE, 17 February 2014 (2014-02-17), pages 1-4), an automatic electroencephalography (EEG) noise removal method for coherence analysis is proposed which uses ICA for getting each ICs. Each ICs are analyzed by exponential analysis for distinguishing noise ICs and normal ICs, after which noise ICs for reference input of adaptive filter are used. However, this paper is also silent in compensating irregularities of the signal that are output by the adaptive filter while removing noises.

### SUMMARY

In order to extract the spectrum overlapped, weak, and blind signal from the strong noise, technical solutions for signal denoising and extracting are provided in the present disclosure. In the solution the weak and blind target signal can be extracted from the strong noise. Without needing prior information of the target signal, the filtering process allows to extract the time domain waveform and all frequency components of the target signal under the condition that the noise drowns the target signal and their spectrums overlap partially, so as to lay a foundation for feature extraction and classification diagnosis of the target defects.

According to a first aspect of the present invention, a signal enhancer includes: a delay module coupled to an input of the signal enhancer; an adaptive filter coupled to an output of the delay module, for outputting a target signal; and a parameter adjustment module for adjusting parameters of the adaptive filter by a convergent criterion and an irregular criterion in real-time. The parameter adjustment module includes: an operation unit of the convergent criterion coupled to the input of the enhancer and the output of the adaptive filter, for calculating a minimum mean square of an error signal between the input of the signal enhancer and the output of the adaptive filter as the convergent criterion; an operation unit of the irregular criterion coupled to the output of the adaptive filter, for processing a calculation by a time function of the Hurst exponent to construct the irregular criterion in discrete time series; and an iterative operation unit coupled to the operation unit of the convergent criterion and the operation unit of the irregular criterion, for iteratively calculating parameters of the adaptive filter

$$\mathbf{w}(n+1) = \mathbf{w}(n) + \mu \left\{ 2e(n)\mathbf{h}(n) - \frac{\lambda}{\ln i_1 - \ln i_2} \left[ \frac{\mathbf{h}(n) - \mathbf{h}(n+i_1)}{g(n) - g(n+i_1)} - \frac{\mathbf{h}(n) - \mathbf{h}(n+i_2)}{g(n) - g(n+i_2)} \right] \right\},$$

by means of a cost function

$$J_w = C_w + \lambda H_w \ ,$$

in order to allow the adaptive filter output a denoised target signal under the introduction of the adjusted parameters. In the above formulas, $J_w$ is the cost function, $C_w$ is the convergent criterion, $\lambda$ is the Lagrange multiplier, $H_w$ is the irregular criterion, n is the time ordinal, w(n) is the parameter matrix of the adaptive filter, $\mu$ is the iteration step size, $e(n)$ is the error signal, h(n) is a matrix h(n)= $[h(n) \ h(n-1) \ ... \ h(n-L)]^T$, where $h(n)$ is the output of the delay module applied to the input of the adaptive filter and L is the length of the adaptive filter, $g(n)$ is the output of the adaptive filter, and $i_1, i_2$ are the ordinal intervals.

In an embodiment, the operation unit of the irregular criterion is configured to calculate a minimum value of

$$H_w = \frac{\ln E\{[g(n) - g(n+i_1)]^2\} - \ln E\{[g(n) - g(n+i_2)]^2\}}{2(\ln i_1 - \ln i_2)}$$

in discrete circumstance as the irregular criterion, by a structure function constructed by the continuous time signal and the time function of the Hurst exponent expression, wherein, E{·} represents the mathematical expectation, n is the time ordinal, $g(n)$ is the output of the adaptive filter, and $i_1, i_2$ are the ordinal intervals.

In an embodiment, the iterative operation unit is configured to minimize the cost function during the iteration calculation of the adaptive filter parameters, in order to obtain optimal parameters of the filter.

According to a second aspect of the present invention, a signal processing method includes: inputting a signal into an adaptive filter through a delay module; adjusting parameters of the adaptive filter in real-time by means of a convergent criterion and an irregular criterion; and outputting a target signal by the adaptive filter with the adjusted parameters after optimization; wherein, adjusting parameters of the adaptive filter in real-time by means of a convergent criterion and an irregular criterion includes: calculating a minimum mean square of an error signal between the input of the delay module and the output of the adaptive filter as the convergent criterion; constructing the irregular criterion of in discrete time series by a time function of the Hurst exponent; calculating parameters of the adaptive filter

$$\mathbf{w}(n+1) = \mathbf{w}(n) + \mu \left\{ 2e(n)\mathbf{h}(n) - \frac{\lambda}{\ln i_1 - \ln i_2} \left[ \frac{\mathbf{h}(n) - \mathbf{h}(n+i_1)}{g(n) - g(n+i_1)} - \frac{\mathbf{h}(n) - \mathbf{h}(n+i_2)}{g(n) - g(n+i_2)} \right] \right\}$$

iteratively, by means of a cost function

$$J_w = C_w + \lambda H_w \ ,$$

in order to allow the adaptive filter output a denoised target signal under the introduction of the adjusted parameters. In the above formulas, $J_w$ is the cost function, $C_w$ is the convergent criterion, $\lambda$ is the Lagrange multiplier, $H_w$ is the irregular criterion, n is the time ordinal, w(n) is the parameter matrix of the adaptive filter, $\mu$ is the iteration step size, $e(n)$ is the error signal, h(n) is a matrix h(n)=$[h(n) \ h(n-1) \ ... \ h(n-L)]^T$, where $h(n)$ is the output of the delay module applied to the input of the adaptive filter and L is the length of the adaptive filter, $g(n)$ is the output of the adaptive filter, and $i_1, i_2$ are the ordinal intervals.

In an embodiment, the method further includes calculating a minimum value of

$$H_w = \frac{\ln E\{[g(n) - g(n+i_1)]^2\} - \ln E\{[g(n) - g(n+i_2)]^2\}}{2(\ln i_1 - \ln i_2)}$$

in discrete circumstance as the irregular criterion, by a structure function constructed by the continuous time signal and the time function of the Hurst exponent expression, wherein, $E\{\cdot\}$ represents the mathematical expectation, n is the time ordinal, $g(n)$ is the output of the adaptive filter, and $i_1$, $i_2$ are the ordinal intervals.

In an embodiment, the method further includes minimizing the cost function during the iteration calculation of the adaptive filter parameters to obtain optimal parameters of the filter.

According to a third aspect of the present invention, a signal detection system, including the signal enhancer.

In an embodiment, the signal detection system includes at least one sensor coupled to the signal enhancer. In an embodiment, the sensor includes a piezoelectric ceramics element.

According to a fourth aspect of the present invention, a computer-readable storage medium having stored thereon instructions for causing one or more processer to execute the method.

Compared with the prior art, the disclosure has advantages as being:

　1) suitable for the extracting and denoising of the weak target signal whose spectrum has an overlap with the one of the strong noise;
　2) suitable for the extracting of the unknown and blind target signal; and
　3) able to extract the time domain waveform and all frequency components of the target signal.

## BRIEF DESCRIPTION OF THE DRAWINGS

Exemplary embodiments of the invention will now be described with reference to the accompanying drawings, in which

　Figure 1 is a schematic structure block diagram of an enhancer according to the present invention;
　Figure 2 illustrates the schematic diagram of an adaptive filter of the enhancer in Figure 1;
　Figure 3 shows along with the variation of the time ordinal, changing curves of the first four parameters of the adaptive filter;
　Figure 4 illustrates an application example in an embodiment of the present invention ;
　Figure 5 shows the noisy signal at the given vehicle speed;
　Figure 6 shows rail crack signals denoised and extracted by the signal enhancer according to the present invention from the noisy signal illustrated in Figure 5; and
　Figure 7 is the time-frequency distribution of the denoised and extracted result (shown in Figure 6) by the signal enhancer according to the present invention .

## DETAILED DESCRIPTION

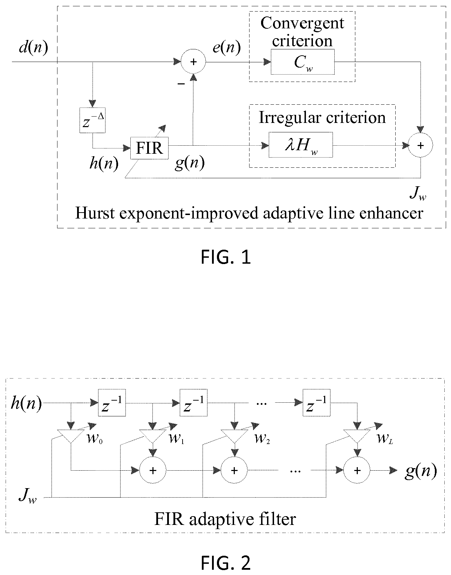

The present invention provides for extracting and denoising solutions for the weak and blind signal based on a signal enhancer (such as an adaptive line enhancer). The main body of the solution is a Hurst exponent-improved signal enhancer. As shown in Figure 1, in an embodiment, the improved enhancer includes the following four parts: a delay module, an adaptive filter, a convergent criterion, and an irregular criterion, which will be described in detail below.

FIRST PART - Delay module

As shown in Figure 1, $z^{-\Delta}$ is the delay module, z represents the Z transform, and $\Delta$ is the delay length. If a discrete noisy signal $d(n)$ is input into the delay module, then a delayed signal $h(n)$ is output. Due to the delay module, $h(n)$ and $d(n)$ has the following relationship:

$$h(n) = d(n-\Delta),$$

assuming that the input $d(n)=r(n)+q(n)$, where $r(n)$ is the target signal and $q(n)$ is the noise.

Thus, when the delay length $\Delta$ is bigger than the correlation length of the noise $q(n)$ and smaller than the correlation length of the target signal $r(n)$, the correlation between h(n)and the noise $q(n)$ will be diminished by the delay module. Then, some of the noise will be suppressed due to the correlation.

SECOND PART - Adaptive filter

The adaptive filter in Figure 1 can be a Finite Impulse Response (FIR) adaptive filter, whose structure is shown in Figure 2. Similarly, $z^{-1}$ is a delay with length 1, $L$ is the length of the FIR adaptive filter, $w_0, w_1, ..., w_L$ are the parameters of the FIR adaptive filter, and $J_w$ is the cost function. Due to the FIR adaptive filter, $g(n)$ and $h(n)$ has the following relationship:

$$g(n) = \mathbf{w}^T \mathbf{h}(n),$$

where $w(n)=[w_0(n)\ w_1(n)\ ...\ w_L(n)]^T$, $h(n)=[h(n)\ h(n-1)\ ...\ \mathrm{h}(n-L)]^T$, and the superscript T stands for transposition.

FIR adaptive filter is an optimal estimator of signal based on the optimization criterion. In an embodiment of the present disclosure, a cost function $J_w$ is put on the traditional FIR filter, and the filter parameters will update iteratively under the real-time adjustment of the adaptive algorithm, then the cost function will meet the requirement of the optimization objective and the FIR adaptive filter will adapt to the target signal. Therefore, as inputting the de-correlated signal $h(n)$ into the FIR adaptive filter, the filter parameters $w_0, w_1, ..., w_L$ will update adaptively according to the restriction of the cost function, and the output $g(n)$ will be the estimation of the target signal $r(n)$ i.e. the denoised and extracted signal.

THIRD PART - Convergent criterion

The cost function $J_w$ in Figure 1 consists of two criteria, one of which is the convergent criterion. The convergent criterion is constructed by the error signal $e(n)$ between the input of the enhancer $d(n)$ and the output $g(n)$:

$$e(n) = d(n) - g(n),$$

$$C_w = E\{e^2(n)\},$$

where $E\{\cdot\}$ is the mathematical expectation. The convergent criterion is defined as the minimum of $C_w$, in which the mean square error is minimized. The convergent criterion limits the amplitude of the error signal in the filtering process so that the enhancer will not diverge in the denoising and extracting process. When the error signal $e(n)$ is too big, the FIR adaptive filter and the enhancer will diverge and the target signal $r(n)$ will not be properly tracked. In this circumstance, the output $g(n)$ is no longer the estimation of the target signal $r(n)$ and the denoising and extracting purpose of the enhancer will not be realized.

FOURTH PART - Irregular criterion

In order to heighten the enhancer's response to the target signal having specific irregularity while removing the noise, the irregular criterion is introduced into the cost function. Since the irregularity of a signal can be expressed by its Hurst exponent, while the cost function should be constructed by the time signal in the enhancer, thus the irregular criterion should be formulated by the time function of the Hurst exponent.

1) The structure function of a continuous time signal g(t) are established as follows:

$$S(\tau) = E\{[g(t) - g(t+\tau)]^2\},$$

where $t$ represents the time and $\tau$ is the time shift of signal $g(t)$. When the Hurst exponent $H$ of $g(t)$ is invariant to the time, its power-law relationship with the structure function $S(\tau)$ can be expressed as follows,

$S(\tau) = V_H \tau^{2H}$, here $V_H = \Gamma(1-2H)\dfrac{\cos(\pi H)}{\pi H}$ . Signal $g(t)$ is the time trace of a fractional Brownian motion, satisfying

$$g(t) = \frac{1}{\Gamma(H+1/2)}\left[\int_{-\infty}^{0}\left(|t-t'|^{H-1/2}-|t'|^{H-1/2}\right)dB(t') + \int_{0}^{t}|t-t'|^{H-1/2}\,dB(t')\right],$$

especially when t=0, g(0)=0, where $t'$ is the time, $H$ is the Hurst exponent (0<H<1), $B(t')$ stands for the time function of the Brownian motion, and $\Gamma(\cdot)$ is the Gamma function. According to the power-law relationship, when $H$ of the signal $g(t)$ is specified, the structure function $S(\tau)$ is merely a function of the time shift $\tau$. Therefore, $H$ can be expressed by the time function constructed by the structure function and its time shift.

2) The time function of the Hurst exponent can be established in the following way:

Take two different time shifts $\tau_1$ and $\tau_2$ and construct their structure functions as

$$S(\tau_1) = V_H \tau_1^{2H},$$

$$S(\tau_2) = V_H \tau_2^{2H}.$$

Then make a division of the two formulations and eliminate the irrelevant factor $V_H$, we have

$$\frac{S(\tau_1)}{S(\tau_2)} = \left(\frac{\tau_1}{\tau_2}\right)^{2H}.$$

Take a logarithm of both sides of the equation and the Hurst exponential expression based on the structure function and its time shift is obtained

$$H = \frac{\ln E\{[g(t)-g(t+\tau_1)]^2\} - \ln E\{[g(t)-g(t+\tau_2)]^2\}}{2(\ln\tau_1 - \ln\tau_2)},$$

and this expression is a time function. The Hurst exponent can be used to describe the irregularity of the signal, in this way, the irregularity of the signal can be acquired by the time function of the Hurst exponent.

It has been proven that $H$ of the defect signal is smaller than that of the noise, therefore the minimum of $H_w$ is defined as the irregular criterion:

$$H_w = \frac{\ln E\{[g(n)-g(n+i_1)]^2\} - \ln E\{[g(n)-g(n+i_2)]^2\}}{2(\ln i_1 - \ln i_2)},$$

where $g(n)$ is the discrete time series of $g(t)$, $i_1$ and $i_2$ are the ordinal intervals defined as $i_1 = \tau_1/t_s$ and $i_1 = \tau_1/t_s$, while $t_s$ is the sampling time of the discrete time signal. Because the irregularity featured by the Hurst exponent is irrelevant to the amplitude and spectrum of the signal, the irregular criterion has the ability to adapt to the target signal with small $H$ when there is high-amplitude noise or spectrum overlap.

In an example of calculation, take two different time shifts $\tau_1$=90 $\mu$s and $\tau_2$=110 $\mu$s, use 30 points after the current time to calculate the mathematical expectation of output $g(n)$, then structure functions $S(\tau_1)$ and $S(\tau_2)$ will be obtained accordingly. Afterward, substitute the structure functions $S(\tau_1)$, $S(\tau_2)$ and the time shifts $\tau_1$, $\tau_2$ into the time function of $H$, and the cost function of the adaptive filter can be established thereon.

3) On the basis of the convergent criterion and the irregular criterion, the cost function of the enhancer can be constructed as follows:

$$J_w = C_w + \lambda H_w,$$

where $\lambda$ is the Lagrange multiplier. In an embodiment, the convergent criterion and the irregular criterion can be added

with $\lambda$=50 to obtain the cost function of the enhancer. In the optimization process, the convergent criterion works with the irregular criterion together, in order to take the minimum of the cost function as the optimization objective of the adaptive filter in the enhancer.

Aiming to obtain the parameters of the adaptive filter based on the cost function, the gradient of the cost function $J_w$ with regard to the parameters is deduced as

$$\nabla J_w = -2E\{e(n)\mathbf{h}(n)\} + \frac{\lambda}{\ln i_1 - \ln i_2}\left\{ \frac{E\{[g(n)-g(n+i_1)][\mathbf{h}(n)-\mathbf{h}(n+i_1)]\}}{E\{[g(n)-g(n+i_1)]^2\}} - \frac{E\{[g(n)-g(n+i_2)][\mathbf{h}(n)-\mathbf{h}(n+i_2)]\}}{E\{[g(n)-g(n+i_2)]^2\}} \right\}$$

Then according to the stochastic gradient descent algorithm, the recursion formula of the parameters can be expressed by

$$\mathbf{w}(n+1) = \mathbf{w}(n) + \mu\left\{ 2e(n)\mathbf{h}(n) - \frac{\lambda}{\ln i_1 - \ln i_2}\left[ \frac{\mathbf{h}(n)-\mathbf{h}(n+i_1)}{g(n)-g(n+i_1)} - \frac{\mathbf{h}(n)-\mathbf{h}(n+i_2)}{g(n)-g(n+i_2)} \right] \right\},$$

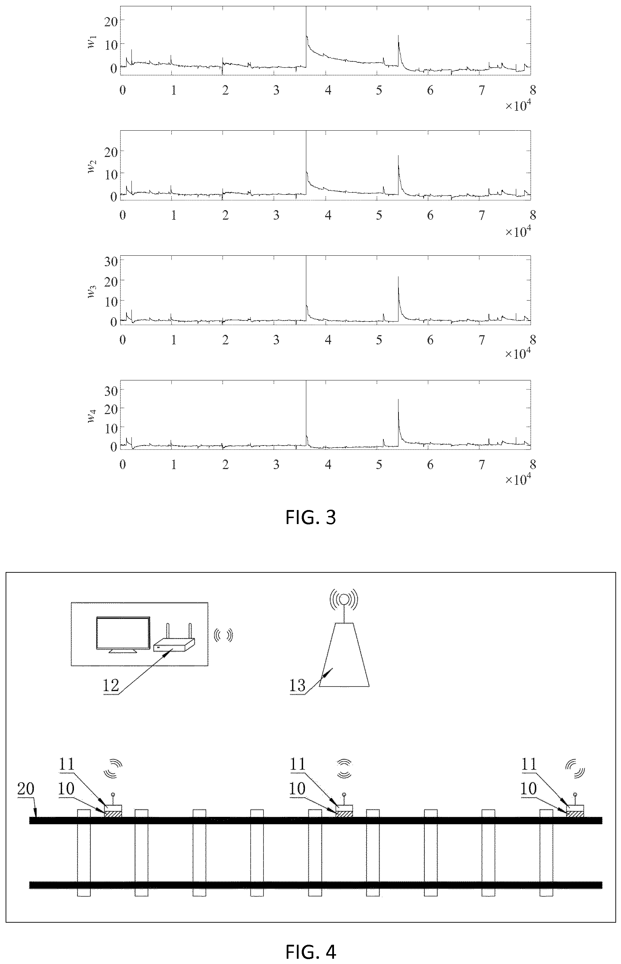

where $\mu$ is the iteration step size. At last, input the noisy signal into the enhancer, the parameters w(n) of the FIR adaptive filter and the output $g(n)$ are both optimized by the cost function, for obtaining the optimums of them and realizing the denoising and extracting purpose. In an embodiment, step size $\mu$=0.000001, the delay length $\Delta$=10, and the filter length L=26 are substituted into the above recursion formula to obtain w(n). Here, along with the variation of the time ordinal within 8000, changing curves of the first four parameters of the adaptive filter are shown in Figure 3.

In some embodiments, the enhancer can be implemented as a signal processor/computer including a plurality of modules coupled with the above mentioned four parts: the delay module, the adaptive filter, the parameter adjustment module, and so on. After the input noisy signal $d(n)$ going through the delay module and the adaptive filter, the denoised output $g(n)$ is obtained. At the same time, the error signal $e(n)$ between the noisy signal $d(n)$ and the output $g(n)$ as well as the output $g(n)$ are utilized by the parameter adjustment module according to the recursion formula to obtain the real-time optimized parameters $\mathbf{w}(n)$, in which the denoised target signal will be output under the adjustment of the adaptive filter. Finally, the target signal, such as a weak and blind signal, will be extracted as the output of the parameter updated adaptive filter.

Figure 4 illustrates a schematic diagram of one application scenario in an embodiment of the present invention . In the embodiment, one or more sensors 10 (such as piezoelectric ceramics sensors) can be mounted on a rail track 20, while each of the sensors can be coupled to a local computing device 11. Data of sensor 10 can be transferred to the remote computing device 12 through a communication device 13. The data acquired by sensor 10 is usually accompanied by high-amplitude noise caused by a passing train. The enhancer can be configured by the local computing device 11 or the remote computing device 12, which will perform denoising and extracting on the signal acquired by the AE sensors.

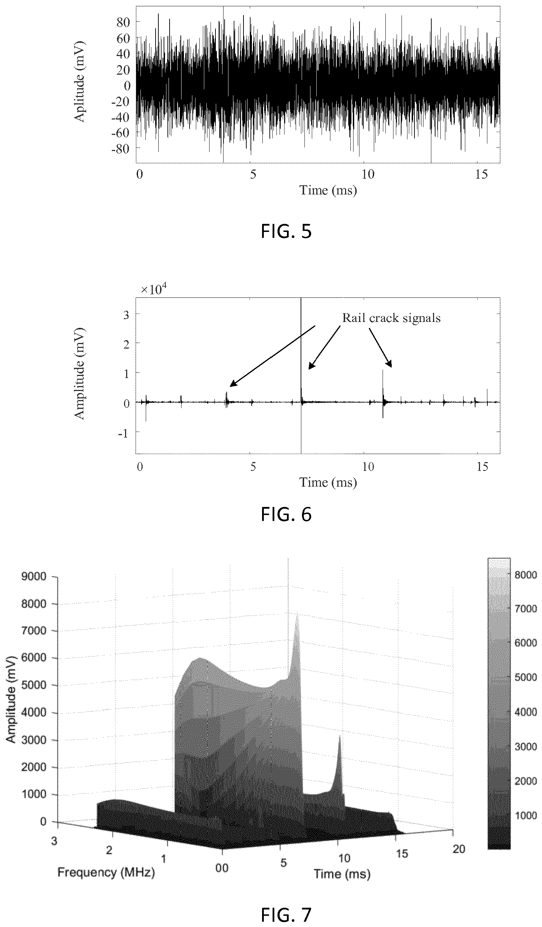

Figure 5 shows the acquired noisy signal at a certain vehicle speed (such as 140 km/h), which contains the weak simulated rail crack signal. The amplitude of the noise is close to 100 mV, while the rail crack signal is totally submerged and unrecognizable.

Figure 6 shows the rail crack signal denoised and extracted by the signal enhancer of the present invention from the noisy signal illustrated in Figure 5. Shown as the denoised result, the present disclosure can extract three rail crack AE signals, in which the amplitude of the signal can be enhanced to $3.5\times10^4$ mV. Comparing the signal before and after denoising, the Peak Signal to Noise Ratio (PSNR) of the signal is greatly promoted and the amplitude of the target signal is highly enhanced.

Figure 7 shows the time-frequency distribution of the denoised and extracted result (shown in Figure 6) by the signal enhancer of the present invention . Here, the extracted AE signal contains the low-frequency components and the high-frequency components of the rail crack signal, indicating that the present disclosure not only can extract the rail crack signal under the strong wheel-rail rolling noise but also be able to retain all frequency components of the rail crack signal when there is a spectrum overlap.

Hence, with regard to the denoising and extracting of the defect signal in high-speed railway wheel/rail detection, the present disclosure takes advantage of the amplitude and spectrum irrelevant irregularity, then introduces the Hurst exponent into the cost function of the adaptive filter, making the filtering process can adapt to the weak rail crack signal under the strong noise. Moreover, the present disclosure is an adaptive method without the prior information of the target signal, which is applicable in blind signal extraction. Therefore, for random rail crack signals, the present disclosure has a good performance in signal extraction.

Similarly, with respect to the noise condition at 48 km/h where the rail crack signal is not submerged and 78 km/h where the rail crack signal starts to be submerged, denoising is performed by the present disclosure as well. Table 1 offers the PSNRs before and after denoising as well as the PSNR increments caused by the enhancer. Here, the PSNR is defined as

$$PSNR = 10\log\frac{\max^2[r(n)]}{\sum_{}^{N-1}q^2(n)/N}$$

where log represents the logarithm with base 10, max[r(n)] is the maximum of the target signal *r(n),* and *N* is the length of the noise *q(n).*

Table 1. PSNRs before and after denoising as well as the PSNR increments at different speeds

| Vehicle speed (km/h) | *PSNR* (dB) before denoising | *PSNR* (dB) after denoising | *PSNR* increment (dB) |
|---|---|---|---|
| 48 | 21.4816 | 46.8860 | 25.4044 |
| 78 | 13.1667 | 55.5219 | 42.3552 |
| 140 | 12.3871 | 59.9151 | 47.5280 |

Before denoising, the PSNR decreases with the increasing vehicle speed, indicating that the increase of the vehicle speed will lead to an increase in noise amplitude and make it more difficult to detect the target signal. After denoised by the enhancer of the present disclosure, the PSNR is promoted and the PSNR increment elevates along with the increasing vehicle speed. This means that the enhancer has better performance under strong noise condition and has the ability to enhance the weak signal to a great extent.

In addition, the enhancer, the method, and the signal detection system according to the present invention not only can be applied on rail defect detection, but also can be applied in other fields, such as the detection of the defect signals from weak cracks on bearings of large rotating machines, the exploration of unsteady seismic signal and so on.

It should be recognized that embodiments of the present disclosure can be implemented or embodied via computer hardware, a combination of both hardware and software, or by computer instructions stored in a non-transitory computer-readable memory. The methods can be implemented in computer programs using standard programming techniques-including a non- transitory computer-readable storage medium configured with a computer program, where the storage medium so configured causes a computer to operate in a specific and predefined manner-according to the methods and figures described in this Specification. Each program may be implemented in a high level procedural or object oriented programming language to communicate with a computer system. However, the programs can be implemented in assembly or machine language, if desired. In any case, the language can be a compiled or interpreted language. Moreover, the program can run on dedicated integrated circuits programmed for that purpose.

Further, methodologies may be implemented in any type of computing platform that is operatively connected to a suitable tomography data scanning device, including but not limited to, personal computers, mini-computers, main-frames, workstations, networked or distributed computing environments, computer platforms separate, integral to, or in communication with charged particle tools or other imaging devices, and the like. Aspects of the present disclosure may be implemented in machine readable code stored on a non-transitory storage medium or device, whether removable or integral to the computing platform, such as a hard disc, optical read and/or write storage mediums, RAM, ROM, and the like, so that it is readable by a programmable computer, for configuring and operating the computer when the storage media or device is read by the computer to perform the procedures described herein. Moreover, machine-readable code, or portions thereof, may be transmitted over a wired or wireless network. The disclosure described herein includes these and other various types of non- transitory computer-readable storage media when such media contain instructions or programs for implementing the steps described above in conjunction with a microprocessor or other data processor. The disclosure also includes the computer itself when programmed according to the methods and techniques described herein.

The above are only preferred embodiments for the present invention, and the invention is not limited to the above-described embodiments. Various modifications and changes can be made to the technical solutions and embodiments within the scope of the claims.

**Claims**

1.   A signal enhancer, comprising

a delay module ($Z^{-\Delta}$) coupled to an input (d(n)) of the signal enhancer an adaptive filter (FIR) coupled to an output of the delay module, for outputting a target signal (g(n)); and

a parameter adjustment module for adjusting parameters of the adaptive filter by a convergent criterion and an irregular criterion in real-time, wherein the parameter adjustment module includes:

an operation unit of the convergent criterion coupled to the input of the enhancer and the output of the adaptive filter, for calculating a minimum mean square of an error signal (e(n)) between the input of the signal enhancer and the output of the adaptive filter (FIR) as the convergent criterion

an operation unit of the irregular criterion coupled to the output of the adaptive filter, for processing a calculation by a time function of the Hurst exponent to construct the irregular criterion in discrete time series; and

an iterative operation unit coupled to the operation unit of the convergent criterion and the operation unit of the irregular criterion, for iteratively calculating parameters of the adaptive filter

$$\mathbf{w}(n+1) = \mathbf{w}(n) + \mu \left\{ 2e(n)\mathbf{h}(n) - \frac{\lambda}{\ln i_1 - \ln i_2} \left[ \frac{\mathbf{h}(n) - \mathbf{h}(n+i_1)}{g(n) - g(n+i_1)} - \frac{\mathbf{h}(n) - \mathbf{h}(n+i_2)}{g(n) - g(n+i_2)} \right] \right\},$$

by means of a cost function

$$J_w = C_w + \lambda H_w \ ,$$

in order to allow the adaptive filter output a denoised target signal under the introduction of the adjusted parameters,

wherein, $J_w$ is the cost function, $C_w$ is the convergent criterion, $\lambda$ is the Lagrange multiplier, $H_w$ is the irregular criterion, n is the time ordinal, w(n) is the parameter matrix of the adaptive filter, $\mu$ is the iteration step size, *e(n)* is the error signal,

h(n) is a matrix h(n)=[*h(n) h(n-1) ... h(n-L)*]$^T$, where *h(n)* is the output of the delay module applied to the input of the adaptive filter and L is the length of the adaptive filter,

*g(n)* is the output of the adaptive filter, and $i_1$, $i_2$ are the ordinal intervals.

2. The signal enhancer according to claim 1, wherein the operation unit of the irregular criterion is configured to calculate a minimum value of

$$H_w = \frac{\ln E\{[g(n) - g(n+i_1)]^2\} - \ln E\{[g(n) - g(n+i_2)]^2\}}{2(\ln i_1 - \ln i_2)}$$

in discrete circumstance as the irregular criterion, by a structure function constructed by the continuous time signal and the time function of the Hurst exponent expression,

and wherein, *E{·}* represents the mathematical expectation, n is the time ordinal, *g(n)* is the output of the adaptive filter, and $i_1$, $i_2$ are the ordinal intervals.

3. The signal enhancer according to claim 1 or 2, wherein the iterative operation unit is configured to minimize the cost function during the iteration calculation of the adaptive filter parameters, in order to obtain optimal parameters of the filter.

4. A signal processing method, comprising:

inputting a signal (d(n)) into an adaptive filter (FIR) through a delay module ($Z^{-\Delta}$);

adjusting parameters of the adaptive filter in real-time by means of a convergent criterion and an irregular criterion; and

outputting a target signal (g(n)) by the adaptive filter (FIR) with the adjusted parameters after optimization;

wherein, adjusting parameters of the adaptive filter in real-time by means of a convergent criterion and an irregular criterion includes:

calculating a minimum mean square of an error signal (e(n)) between the input of the delay module and the output of the adaptive filter as the convergent criterion;
constructing the irregular criterion of in discrete time series by a time function of the Hurst exponent;
calculating parameters of the adaptive filter

$$\mathbf{w}(n+1) = \mathbf{w}(n) + \mu \left\{ 2e(n)\mathbf{h}(n) - \frac{\lambda}{\ln i_1 - \ln i_2} \left[ \frac{\mathbf{h}(n) - \mathbf{h}(n+i_1)}{g(n) - g(n+i_1)} - \frac{\mathbf{h}(n) - \mathbf{h}(n+i_2)}{g(n) - g(n+i_2)} \right] \right\}$$

iteratively, by means of a cost function

$$J_w = C_w + \lambda H_w \ ,$$

in order to allow the adaptive filter output a denoised target signal under the introduction of the adjusted parameters,
wherein, $J_w$ is the cost function, $C_w$ is the convergent criterion, $\lambda$ is the Lagrange multiplier, $H_w$ is the irregular criterion, n is the time ordinal, w(n) is the parameter matrix of the adaptive filter, $\mu$ is the iteration step size, e(n) is the error signal,
h(n) is a matrix $h(n)=[h(n) \ h(n-1) \ ... \ h(n-L)]^T$, where $h(n)$ is the output of the delay module applied to the input of the adaptive filter and L is the length of the adaptive filter,
g(n) is the output of the adaptive filter, and $i_1$, $i_2$ are the ordinal intervals.

5. The method according to claim 4, further comprising calculating a minimum value of

$$H_w = \frac{\ln E\{[g(n) - g(n+i_1)]^2\} - \ln E\{[g(n) - g(n+i_2)]^2\}}{2(\ln i_1 - \ln i_2)}$$

in discrete circumstance as the irregular criterion, by a structure function constructed by the continuous time signal and the time function of the Hurst exponent expression,
wherein, E{·} represents the mathematical expectation, n is the time ordinal, g(n) is the output of the adaptive filter, and $i_1$, $i_2$ are the ordinal intervals.

6. The method according to claim 4 or 5, further comprising
minimizing the cost function during the iteration calculation of the adaptive filter parameters to obtain optimal parameters of the filter.

7. A signal detection system, comprising the signal enhancer according to any one of claims 1 to 3.

8. The signal detection system according to claim 7, comprising at least one sensor (10) coupled to the signal enhancer.

9. The signal detection system according to claim 8, wherein the sensor (10) includes a piezoelectric ceramics element.

10. A computer-readable storage medium having stored thereon instructions which, when executed by one or more processors , cause the one ore more processors to carry out the method according to any one of claims 4 to 6.

**Patentansprüche**

1. Signalverstärker, umfassend

ein Verzögerungsmodul ($z^{-\Delta}$), das mit einer Eingabe (d(n)) des Signalverstärkers gekoppelt ist;
ein adaptives Filter (FIR), das mit einer Ausgabe des Verzögerungsmoduls gekoppelt ist, um ein Zielsignal (g(n)) auszugeben; und
ein Parametereinstellmodul zum Einstellen von Parametern des adaptiven Filters durch ein konvergentes Kriterium und ein irreguläres Kriterium in Echtzeit, wobei das Parametereinstellmodul umfasst:

eine Betätigungseinheit des konvergenten Kriteriums, die mit der Eingabe des Verstärkers und der Ausgabe des adaptiven Filters gekoppelt ist, um ein minimales mittleres Abweichungsquadrat eines Fehlersignals (e(n)) zwischen der Eingabe des Signalverstärkers und der Ausgabe des adaptiven Filters (FIR) als das konvergente Kriterium zu berechnen;

eine Betätigungseinheit des unregelmäßigen Kriteriums, die mit der Ausgabe des adaptiven Filters gekoppelt ist, zum Verarbeiten einer Berechnung durch eine Zeitfunktion des Hurst-Exponenten, um das unregelmäßige Kriterium in diskreten Zeitreihen zu konstruieren; und

eine iterative Betätigungseinheit, die mit der Betätigungseinheit des konvergenten Kriteriums und der Betätigungseinheit des irregulären Kriteriums gekoppelt ist, zum iterativen Berechnen von Parametern des adaptiven Filters

$$\mathbf{w}(n+1) = \mathbf{w}(n) + \mu \left\{ 2e(n)\mathbf{h}(n) - \frac{\lambda}{\ln i_1 - \ln i_2} \left[ \frac{\mathbf{h}(n) - \mathbf{h}(n+i_1)}{g(n) - g(n+i_1)} - \frac{\mathbf{h}(n) - \mathbf{h}(n+i_2)}{g(n) - g(n+i_2)} \right] \right\} ,$$

mit Hilfe einer Kostenfunktion

$$J_w = C_w + \lambda H_w \ ,$$

um zu ermöglichen, dass der adaptive Filter ein entrauschtes Zielsignal unter der Einführung der eingestellten Parameter ausgibt,

wobei $J_w$ die Kostenfunktion ist, $C_w$ das konvergente Kriterium ist, $\lambda$ der Lagrange-Multiplikator ist, $H_w$ das unregelmäßige Kriterium ist, *n* das Zeitordinale ist, w(n) die Parametermatrix des adaptiven Filters ist, $\mu$ die Iterationsschrittgröße ist, *e(n)* das Fehlersignal ist,

h(n) eine Matrix h(n)=[*h(n) h(n-1) ... h(n-L)*]$^T$ist, wobei *h(n)* die Ausgabe des auf die Eingabe des adaptiven Filters angewendeten Verzögerungsmoduls und L die Länge des adaptiven Filters ist,

g(n) die Ausgabe des adaptiven Filters ist, und $i_1$, $i_2$ die ordinalen Intervalle sind.

2. Signalverstärker nach Anspruch 1, wobei die Betätigungseinheit des irregulären Kriteriums konfiguriert ist, um einen Minimalwert von

$$H_w = \frac{\ln E\{[g(n) - g(n+i_1)]^2\} - \ln E\{[g(n) - g(n+i_2)]^2\}}{2(\ln i_1 - \ln i_2)}$$

in einem diskreten Fall als das irreguläre Kriterium durch eine Strukturfunktion zu berechnen, die durch das kontinuierliche Zeitsignal und die Zeitfunktion des Hurst-Exponenten-Ausdrucks konstruiert ist,

und wobei *E{·}* die mathematische Erwartung darstellt, n die zeitliche Ordinale ist, g(n) die Ausgabe des adaptiven Filters ist und $i_1$, $i_2$ die ordinalen Intervalle sind.

3. Signalverstärker nach Anspruch 1 oder 2, wobei die iterative Betätigungseinheit konfiguriert ist, um die Kostenfunktion bei der Iterationsberechnung der adaptiven Filterparameter zu minimieren, um optimale Parameter des Filters zu erhalten.

4. Signalverarbeitungsverfahren, umfassend:

Eingeben eines Signals (d(n)) in ein adaptives Filter (FIR) durch ein Verzögerungsmodul ($z^{-\Delta}$);
Einstellen von Parametern des adaptiven Filters in Echtzeit mit Hilfe eines konvergenten Kriteriums und eines irregulären Kriteriums; und
Ausgeben eines Zielsignals (g(n)) durch das adaptive Filter (FIR) mit den eingestellten Parametern nach einer Optimierung;
wobei das Einstellen von Parametern des adaptiven Filters in Echtzeit mit Hilfe eines konvergenten Kriteriums und eines irregulären Kriteriums aufweist:

Berechnen eines minimalen mittleren Abweichungsquadrats eines Fehlersignals (e(n)) zwischen der Eingabe des Verzögerungsmoduls und der Ausgabe des adaptiven Filters als das konvergente Kriterium;
Konstruieren des irregulären Kriteriums in diskreten Zeitreihen durch eine Zeitfunktion des Hurst-Exponenten;

Berechnen der Parameter des adaptiven Filters

$$\mathbf{w}(n+1) = \mathbf{w}(n) + \mu \left\{ 2e(n)\mathbf{h}(n) - \frac{\lambda}{\ln i_1 - \ln i_2} \left[ \frac{\mathbf{h}(n) - \mathbf{h}(n+i_1)}{g(n) - g(n+i_1)} - \frac{\mathbf{h}(n) - \mathbf{h}(n+i_2)}{g(n) - g(n+i_2)} \right] \right\}$$

iterativ,
mit Hilfe einer Kostenfunktion

$$J_w = C_w + \lambda H_w \,,$$

um zu ermöglichen, dass der adaptive Filter ein entrauschtes Zielsignal unter der Einführung der eingestellten Parameter ausgibt,
wobei $J_w$ die Kostenfunktion ist, $C_w$ das konvergente Kriterium ist, $\lambda$ der Lagrange-Multiplikator ist, $H_w$ das irreguläre Kriterium ist, *n* die zeitliche Ordinale ist, w(n) die Parametermatrix des adaptiven Filters ist, $\mu$ die Iterationsschrittgröße ist, *e(n)* das Fehlersignal ist,
h(n) eine Matrix h(n)=[*h(n) h(n-1) ... h(n-L)*]$^T$ ist, wobei *h(n)* die Ausgabe des auf die Eingabe des adaptiven Filters angewendeten Verzögerungsmoduls ist und L die Länge des adaptiven Filters ist,
*g(n)* die Ausgabe des adaptiven Filters ist und $i_1, i_2$ die ordinalen Intervalle sind.

5. Verfahren nach Anspruch 4, ferner umfassend

Berechnen eines Minimalwertes von

$$H_w = \frac{\ln E\{[g(n) - g(n+i_1)]^2\} - \ln E\{[g(n) - g(n+i_2)]^2\}}{2(\ln i_1 - \ln i_2)}$$

in einem diskreten Fall als das unregelmäßige Kriterium, durch eine Strukturfunktion, die durch das kontinuierliche Zeitsignal und die Zeitfunktion des Hurst-Exponenten-Ausdrucks konstruiert wird,
wobei $E\{\cdot\}$ die mathematische Erwartung darstellt, n die zeitliche Ordinale ist, *g(n)* die Ausgabe des adaptiven Filters ist und $i_1, i_2$ die ordinalen Intervalle sind.

6. Verfahren nach Anspruch 4 oder 5, ferner umfassend
Minimieren der Kostenfunktion bei der Iterationsberechnung der Parameter des adaptiven Filters, um optimale Parameter des Filters zu erhalten.

7. Signaldetektionssystem, umfassend den Signalverstärker nach einem der Ansprüche 1 bis 3.

8. Signaldetektionssystem nach Anspruch 7, umfassend mindestens einen Sensor (10), der mit dem Signalverstärker gekoppelt ist.

9. Signaldetektionssystem nach Anspruch 8, wobei der Sensor (10) ein piezoelektrisches Keramikelement aufweist.

10. Computerlesbares Speichermedium, das darauf gespeicherte Befehle aufweist, die beim Ausführen durch einen oder mehrere Prozessoren den einen oder die mehreren Prozessoren veranlassen, das Verfahren nach einem der Ansprüche 4 bis 6 auszuführen.

**Revendications**

1. Réhausseur de signal, comprenant

un module de retard ($Z^{-\Delta}$) couplé à une entrée (d(n)) du réhausseur de signal ;
un filtre adaptatif (FIR) couplé à une sortie du module de retard, pour délivrer en sortie un signal cible (g(n)) ; et
un module de réglage de paramètres pour régler des paramètres du filtre adaptatif par un critère de convergence et un critère irrégulier en temps réel, dans lequel le module de réglage de paramètres comprend :

une unité d'opération du critère de convergence couplée à l'entrée du réhausseur et à la sortie du filtre adaptatif, pour calculer un carré moyen minimal d'un signal d'erreur (e(n)) entre l'entrée du réhausseur de signal et la sortie du filtre adaptatif (FIR) comme étant le critère de convergence ;
une unité d'opération du critère irrégulier couplée à la sortie du filtre adaptatif, pour traiter un calcul par une fonction temporelle de l'exposant de Hurst pour construire le critère irrégulier en série temporelle discrète ; et
une unité d'opération itérative couplée à l'unité d'opération du critère de convergence et à l'unité d'opération du critère irrégulier, pour calculer de manière itérative des paramètres du filtre adaptatif

$$\mathbf{w}(n+1) = \mathbf{w}(n) + \mu \left\{ 2e(n)\mathbf{h}(n) - \frac{\lambda}{\ln i_1 - \ln i_2} \left[ \frac{\mathbf{h}(n) - \mathbf{h}(n+i_1)}{g(n) - g(n+i_1)} - \frac{\mathbf{h}(n) - \mathbf{h}(n+i_2)}{g(n) - g(n+i_2)} \right] \right\},$$

au moyen d'une fonction de coût

$$J_w = C_w + \lambda H_w,$$

afin de permettre au filtre adaptatif de délivrer en sortie un signal cible débruité lors de l'introduction des paramètres réglés,
où, $J_w$ est la fonction de coût, $C_w$ est le critère de convergence, $\lambda$ est le multiplicateur de Lagrange, $H_w$ est le critère irrégulier, n est l'ordinal temporel, w(n) est la matrice de paramètres du filtre adaptatif, $\mu$ est la taille de pas d'itération, e(n) est le signal d'erreur,
h(n) est une matrice h(n)=[h(n) h(n-1) ... h(n-L)]$^T$, où h(n) est la sortie du module de retard appliquée à l'entrée du filtre adaptatif et L est la longueur du filtre adaptatif,
g(n) est la sortie du filtre adaptatif, et $i_1$, $i_2$ sont les intervalles ordinaux.

2. Réhausseur de signal selon la revendication 1, dans lequel l'unité d'opération du critère irrégulier est configurée pour calculer une valeur minimale de

$$H_w = \frac{\ln E\{[g(n) - g(n+i_1)]^2\} - \ln E\{[g(n) - g(n+i_2)]^2\}}{2(\ln i_1 - \ln i_2)}$$

en circonstance discrète comme étant le critère irrégulier, par une fonction de structure construite par le signal à temps continu et la fonction temporelle de l'expression de l'exposant de Hurst,
et où, E{·} représente l'espérance mathématique, n est l'ordinal temporel, g(n) est la sortie du filtre adaptatif, et $i_1$, $i_2$ sont les intervalles ordinaux.

3. Réhausseur de signal selon la revendication 1 ou 2, dans lequel l'unité d'opération itérative est configurée pour minimiser la fonction de coût lors du calcul d'itération des paramètres de filtre adaptatif, afin d'obtenir des paramètres optimaux du filtre.

4. Procédé de traitement de signal, comprenant :

l'entrée d'un signal (d(n)) dans un filtre adaptatif (FIR) à travers un module de retard (Z$^{-\Delta}$);
le réglage de paramètres du filtre adaptatif en temps réel au moyen d'un critère de convergence et d'un critère irrégulier ; et
la sortie d'un signal cible (g(n)) par le filtre adaptatif (FIR) avec les paramètres réglés après optimisation ;
dans lequel, le réglage de paramètres du filtre adaptatif en temps réel au moyen d'un critère de convergence et d'un critère irrégulier comprend :

le calcul d'un carré moyen minimal d'un signal d'erreur (e(n)) entre l'entrée du module de retard et la sortie du filtre adaptatif comme étant le critère de convergence ;
la construction du critère irrégulier en série temporelle discrète par une fonction temporelle de l'exposant de Hurst ;

le calcul de paramètres du filtre adaptatif

$$\mathbf{w}(n+1) = \mathbf{w}(n) + \mu \left\{ 2e(n)\mathbf{h}(n) - \frac{\lambda}{\ln i_1 - \ln i_2} \left[ \frac{\mathbf{h}(n) - \mathbf{h}(n+i_1)}{g(n) - g(n+i_1)} - \frac{\mathbf{h}(n) - \mathbf{h}(n+i_2)}{g(n) - g(n+i_2)} \right] \right\}$$

de manière itérative, au moyen d'une fonction de coût

$$J_w = C_w + \lambda H_w ,$$

afin de permettre au filtre adaptatif de délivrer en sortie un signal cible débruité lors de l'introduction des paramètres réglés,

où, $J_w$ est la fonction de coût, $C_w$ est le critère de convergence, $\lambda$ est le multiplicateur de Lagrange, $H_w$ est le critère irrégulier, n est l'ordinal temporel, $w(n)$ est la matrice de paramètres du filtre adaptatif, $\mu$ est la taille de pas d'itération, $e(n)$ est le signal d'erreur,

$h(n) = [h(n)\ h(n-1)\ ...\ h(n-L)]^T$ h(n) est une matrice , où $h(n)$ est la sortie du module de retard appliquée à l'entrée du filtre adaptatif et L est la longueur du filtre adaptatif,

$g(n)$ est la sortie du filtre adaptatif, et $i_1$, $i_2$ sont les intervalles ordinaux.

**5.** Procédé selon la revendication 4, comprenant en outre

le calcul d'une valeur minimale de

$$H_w = \frac{\ln E\{[g(n) - g(n+i_1)]^2\} - \ln E\{[g(n) - g(n+i_2)]^2\}}{2(\ln i_1 - \ln i_2)}$$

en circonstance discrète comme étant le critère irrégulier, par une fonction de structure construite par le signal à temps continu et la fonction temporelle de l'expression de l'exposant de Hurst,

où, E{·} représente l'espérance mathématique, n est l'ordinal temporel, $g(n)$ est la sortie du filtre adaptatif, et $i_1$, $i_2$ sont les intervalles ordinaux.

**6.** Procédé selon la revendication 4 ou 5, comprenant en outre
la minimisation de la fonction de coût lors du calcul d'itération des paramètres de filtre adaptatif pour obtenir des paramètres optimaux du filtre.

**7.** Système de détection de signal, comprenant le réhausseur de signal selon l'une quelconque des revendications 1 à 3.

**8.** Système de détection de signal selon la revendication 7, comprenant au moins un capteur (10) couplé au réhausseur de signal.

**9.** Système de détection de signal selon la revendication 8, dans lequel le capteur (10) comprend un élément céramique piézoélectrique.

**10.** Support de stockage lisible par ordinateur sur lequel sont stockées des instructions qui, lorsqu'elles sont exécutées par un ou plusieurs processeurs, amènent le ou les plusieurs processeurs à réaliser le procédé selon l'une quelconque des revendications 4 à 6.

FIG. 1

FIG. 2

FIG. 3

FIG. 4

FIG. 5

FIG. 6

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3182413 A1

**Non-patent literature cited in the description**

- **LU ZHOU et al.** *Contemporary Inspection and Monitoring for High-Speed Rail System,* http://dx.doi.org/10.5772/intechopen.81159
- **ROSHAHLIZA M RAMLI et al.** A Review of Adaptive Line Enhancers for Noise Cancellation. *Australian Journal of Basic and Applied Sciences,* 01 June 2012, 337-352
- Adaptive EEG noise filtering for coherence analysis. **KANG JUN-SU et al.** INTERNATIONAL WINTER WORKSHOP ON BRAIN COMPUTER INTERFACE (BCI). IEEE, 17 February 2014, 1-4